Europäisches Patentamt

European Patent Office

Office européen des brevets

(19)

(11) **EP 0 765 040 A2**

(12) **EUROPÄISCHE PATENTANMELDUNG**

(43) Veröffentlichungstag:
26.03.1997 Patentblatt 1997/13

(51) Int. Cl.[6]: **H03M 3/02**, H03M 1/12

(21) Anmeldenummer: 96103972.4

(22) Anmeldetag: 13.03.1996

(84) Benannte Vertragsstaaten:
**DE**

(30) Priorität: **19.09.1995 EP 95114755**

(71) Anmelder: **SIEMENS AKTIENGESELLSCHAFT**
**80333 München (DE)**

(72) Erfinder:
• **Kadivar, Sylvie**
**80809 München (DE)**
• **Schmitt-Landsiedel, Doris, Dr.**
**85521 Ottobrunn (DE)**

(54) **Vorrichtung zur Analog-Digital-Wandlung mit unbedingter Stabilität**

(57)     Die erfindungsgemäße Anordnung betrifft einen optimierten Single-loop $\Sigma\Delta$-Analog/Digital-Wandler der im wesentlichen aus einem Summations/Integrationsverstärker-Netzwerk (F), einem 1-Bit-Quantisierer (ADC) und einem 1-Bit-D/A-Wandler (DAC) besteht, wobei die Ordnung des Summations/Integrationsverstärker-Netzwerks (F) > 2 beträgt. Der Anmeldungsgegenstand weist auch nach dem Auftreten von Störspannungen, die beispielsweise durch Ein/Ausschaltvorgänge erzeugt werden, ein selbststabilisierendes Verhalten auf und es bedarf infolgedessen beispielsweise keiner Reset-Einrichtungen.

**FIG 1**

EP 0 765 040 A2

**Beschreibung**

Unter Vorrichtungen zur Anlaog/Digital-Wandlung werden sogenannte Single loop $\Sigma\Delta$-Analog/Digital-Wandler verstanden, bei denen ein Eingang der Vorrichtung gleichzeitig den Eingang eines Summations/Integrationsvertärker-Netzwerkes bildet, dessen Ausgang über einen 1-Bit-Quantisierer mit dem Ausgang der Vorrichtung verbunden ist, wobei der Ausgang der Vorrichtung über einen 1-Bit-Digital/Analog-Wandler mit Rückwärtskoeffizienten gewichtet den Addierern des Summations/Integrationsverstärker-Netzwerkes zugeführt ist.

Aus der Veröffentlichung von J. C. Candy, G. C. Temes, mit dem Titel „Oversampling Delta Sigma Data Converters, Theory, Design and Simulation", IEEE Press, 1992, ISBN 0-87942-285-8, Seiten 1 bis 27 ist beispielsweise ein kaskadierter $\Sigma\Delta$-Analog/Digital-Wandler bekannt, der aus kaskadierten stabilen $\Sigma\Delta$-Analog-Wandlern erster und zweiter Ordnung aufgebaut ist. Die Kaskadierung bewirkt hierbei eine Verbesserung der Rauschunterdrückung, dies wird jedoch durch die Erfordernisse einer höheren Verstärkung der Operationsverstärker, einer besseren Bauteileabstimmung und durch einen zusätzlichen Schaltungsaufwand erkauft.

Ferner ist aus der Veröffentlichung von K. Chao, S. Nadeem, W. L. Lee und G. Sodini mit dem Titel „A Higher Order Topology for Interpolative Modulators for Oversampling A/D Converters", IEEE Trans. Circuits and Systems, Vol. CAS-37, pp. 309 bis 318, March 1990 ein $\Sigma\Delta$-Analog/Digital-Wandler bekannt, bei dem interne Signale vorwärts- und rückwärtsgekoppelt und jeweils durch gewichtete Summationsverstärker zusammengefaßt werden. Nachteilig ist hierbei, daß die Gewichtungskoeffizienten des Vorwärtszweiges klein sind und dies zu großen Kapazitätsflächen führt und daß bei den sehr kleinen Gleichspannungseingangssignalen, die bei $\Sigma\Delta$-Analog/Digital-Wandlern höherer Ordnung vorkommen, korrelierte Signal/Rausch-komponenten (tones) im Basisband auftreten, die eine Dekorrelationsschaltung erforderlich machen.

Durch Single loop $\Sigma\Delta$-Analog/Digital-Wandler mit einer Ordnung größer als 2 werden die obengenannten Nachteile weitgehend vermieden, bisher galten diese Wandler jedoch nur als bedingt stabil. Dies bedeutet, daß diese Wandler zum Beispiel nach dem Auftreten von Störspannungen, die beispielsweise bei Ein/Ausschaltvorgängen erzeugt werden, zu schwingen beginnen und ohne ein externes Rücksetzen von sich aus kein stabiler Betriebszustand mehr erreicht wird.

Die der Erfindung zugrundeliegende Aufgabe besteht nun darin, eine Vorrichtung zur Analog-Digital-Wandlung in Form eines Single loop $\Sigma\Delta$-Analog/Digital-Wandlers mit einer Ordnung größer als 3 anzugeben, die eine unbedingte Stabilität aufweist und somit auch nach dem Auftreten von Störspannung ein selbststabilisierendes Verhalten zeigt infolgedessen keiner Reset-Einrichtung bedarf.

Diese Aufgabe wird erfindungsgemäß durch die Merkmale des Patentanspruchs 1 gelöst.

Die Unteransprüche betreffen vorteilhafte Ausgestaltungen der erfindungsgemäßen Vorrichtung.

Die Erfindung wird nachfolgend anhand der Zeichnungen näher erläutert. Dabei zeigt

Figur 1    ein lineares Ersatzschaltbild der erfindungsgemäßen Vorrichtung und

Figur 2    ein nichtlineares Ersatzschaltbild der erfindungsgemäßen Vorrichtung zusammen mit Detailangaben zu einzelnen Komponenten der erfindungsgemäßen Vorrichtung.

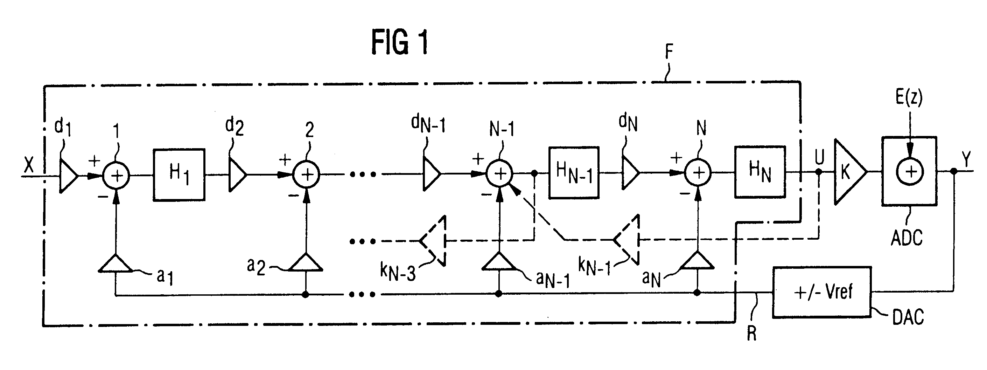

Figur 1 zeigt ein lineares Modell eines erfindungsgemäßen Analog/Digital-Wandlers, bei dem der Eingang X eines Summations/Integrationsverstärker-Netzwerkes F einem Eingang der erfindungsgemäßen Vorrichtung zur Analog/Digital-Wandlung entspricht, ein Eingang U eines 1-Bit-Quantisierers ADC-mit einem Ausgang des Summations/Integrationsverstärker-Netzwerkes F verbunden ist, im Quantisierer ADC eine Verstärkung um den faktor K erfolgt und ein Fehlersignal E(z) hinzuaddiert wird, ein Ausgang des Quantisierer ADC einem Ausgang Y der erfindungsgemäßen Vorrichtung entspricht und ein Rückkopplungszweig R über einen 1-Bit-Digital/Analog-Wandler DAC mit dem Ausgang Y verbunden ist. Der 1 Bit D/A-Wandler DAC beaufschlagt den Rückwärtszweig R abhängig vom Signal am Ausgang Y entweder mit einer positiven oder einer negativen Referenzspannung Vref, wobei Vref beispielsweise +/-1V beträgt.

Das Summations/Integrationsverstärker-Netzwerk F weist die Ordnung N mit $N \geq 3$ auf, wobei N in Reihe geschaltete Summations/Integrationsverstärker-Netzwerkstufn mit je einem Verstärker für einen jeweiligen Vorwärtskoeffizienten $d_1 \ldots d_N$, je einen Addierer 1 ... N, je einen Verstärker für einen jeweiligen Rückwärtskoeffizienten $a_1 \ldots a_N$ sowie je einen Integrierer $H_n \ldots H_N$ auf. Das Signal des Rückwärtszweiges R steht allen Verstärkern für die Rückwärtskoeffizienten $a_1 \ldots a_N$ als Eingangssignal zur Verfügung. Das mit den jeweiligen Rückwärtskoeffizienten $a_1 \ldots a_N$ gewichtete Signal des Rückwärtszweiges wird in den Addierern 1 ... N mit negativem Vorzeichen addiert.

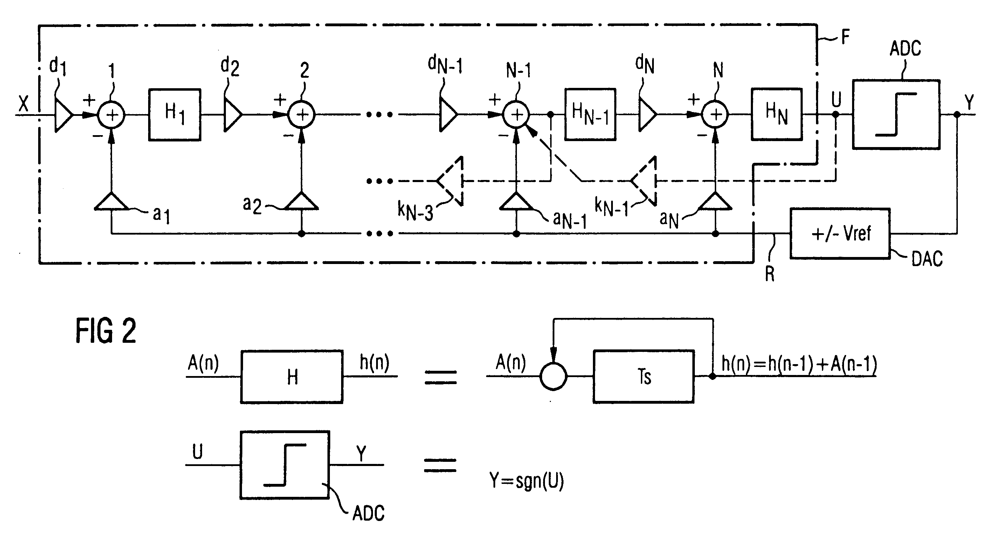

In Figur 2 ist unter anderem ein nichtlineares Modell der erfindungsgemäßen Vorrichtung dargestellt, wobei sich dieses nichtlineare Modell lediglich darin unterscheidet, daß der 1-Bit-Quantisierer ADC durch einstufige stufenförmige Quantisierungskennlinie aufweist und keine Verstärkung mit dem Faktor K erfolt, wobei der Zusammenhang zwischen dem Ausgangssignal und dem Eingangssignal durch die Sprungfunktion $Y = \text{sgn}(U)$ beschrieben wird. Ferner ist in Figur 2 der Integrator H detailliert dargestellt und weist einen Addierer und eine Verzögerungseinrichtung Ts auf, wobei das Ausgangssignal $h(n) = h(n-1) + A(n-1)$ auf einen Eingang des Addierers rückgekoppelt ist, dessen weiterer Ein-

2

gang mit dem Wert A(n) beschaltet ist.

Ferner sind in Figur 1 und 2 eventuell zusätzlich vorgesehene innere Rückkopplungsschleifen mit Verstärkern gestrichelt angedeutet, wobei eine erste innere Rückkoppelschleife einen Verstärker mit einer Verstärkung bzw. einem Schleifenkoeffizienten $k_{N-1}$ aufweist und den Ausgang des Netzwerkes F auf einen Eingang des Addierers N-1 der übernächsten Vorgängerstufe rückkoppelt und wobei, beispielhaft für gegebenenfalls weitere innere Rückkoppelschleifen, eine zweite innere Rückkoppelschleife einen Verstärker mit einer Verstärkung bzw. einem Schleifenkoeffizienten $k_{N-3}$ aufweist und den Ausgang des Addierers N-1 auf einen Eingang des Addierers N-3 der zur Stufe des Addierers N-1 übernächsten Vorgängerstufe rückkoppelt.

Die Koeffizienten der erfindungsgemäßen Vorrichtung zur Analog/Digital-Wandlung werden durch ein im folgenden beschriebenes Verfahren bestimmt, wobei dies der Einfachheit halber am Beispiel ohne innere Rückkoppelschleifen gezeigt wird.

Zunächst wird basierend auf dem linearen Modell eine Systemfunktion Y(z) ermittelt, die wie folgt lautet:

$$Y(z) = \frac{\prod_{i=1}^{N} d_i}{a_1 {}^* D(z)} X(z) + \frac{(z-1)^N}{D(z)} E(z)$$

mit

$$D(z) = (z-1)^N + K^*(a_N {}^* Vref)^* \left[ (z-1)^{N-1} + \left( \sum_{j=0}^{N-2} (z-1)^j {}^* \prod_{i=j+2}^{N} \frac{a_{i-1} {}^* d_i}{a_i} \right) \right].$$

Daraufhin wird aus der Systemfunktion zur Beurteilung der Leistungsfähigkeit der erfindungsgemäßen Vorrichtung hinsichtlich der Rauschunterdrückung ein Quantisierungsrauschen $N_0$ im Basisband f=0 bis f=$f_B$ für eine Abtastfrequenz $f_S$ durch die Formel

$$N_0 = 1/\left( \left( \frac{\sqrt{2N+1}}{\pi^N} {}^* \frac{\sqrt{12}}{\Delta} {}^* M^{N+\frac{1}{2}} \right) {}^* \left( a_1 {}^* Vref {}^* \prod_{i=2}^{N} d_i \right) \right),$$

und ein Spitzenwert des Signal/Rausch-Verhältnisses $SNR_{peak}$ durch die Formel

$$SNR_{peak} = \left( X_{max} {}^* \frac{\sqrt{2N+1}}{\pi^N} {}^* \frac{\sqrt{12}}{\Delta} {}^* M^{N+\frac{1}{2}} \right) {}^* \left( \prod_{i=1}^{N} d_i \right)$$

ermittelt, wobei angenommen wird, daß alle in der Vorrichtung vorhandenen Rauschquellen der erfindungsgemäßen Vorrichtung bis auf das Quantisierungsrauschen des Quantisierers ADC vernachlässigbar sind. Die Größe $X_{max}$ stellt dabei das Maximum der Amplitude am Eingang X der Vorrichtung dar. N bedeutet die Ordnung des Summations/Integrationsverstärker-Netzwerks F und M das Oversampling-Verhältnis, das sich aus dem Verhältnis der Abtastfrequenz $f_S$ des Quantisierers ADC zur Nyquistfrequenz 2*$f_B$ ergibt. Die Größen $d_i$ stellen dabei die Vorwärtskoeffizienten des Summations/Integrationsverstärker-Netzwerks F dar, wobei der Index i vom Eingang X zum Ausgang des Summations/Integrationsverstärker-Netzwerks hin von 1 bis N ansteigt und N > 2 ist.

Aus der Systemfunktion Y(z) wird ferner durch Nullsetzen des Nenners D(z) der Systemfunktion eine Stabilitätsbedingung ermittelt. Hierzu wird die Nennerfunktion D(z) = 0 durch eine Lineartransformation in eine Form gemäß

$$C_N \Psi^N + c_{n-1} \Psi^{N-1} + \ldots c_1 \Psi + c_0 = 0$$

gebracht, woraus sich die Hurwitz-Matrix gemäß

$$\begin{vmatrix} c_{N-1} & c_{N-3} & c_{N-5} & \cdots & 0 \\ c_N & c_{N-2} & c_{N-4} & \cdots & 0 \\ 0 & c_{N-1} & c_{N-3} & \cdots & 0 \\ \vdots & \vdots & \vdots & \ddots & 0 \\ 0 & 0 & 0 & 0 & c_0 \end{vmatrix}$$

ergibt.

Auf die Hurwitz-Matrix läßt sich das Lienard Chipard Stabilitätskriterium anwenden, das besagt, daß die erfindungsgemäße Vorrichtung dann stabil ist, wenn alle Elemente $c_i$ sowie alle geraden oder ungeraden Hurwitz Unterdeterminanten > 0 sind.

Aus dem nichtlinearen Modell gemäß Figur 2 werden darüberhinaus noch weitere Bedingungen, sogenannte Überlastbedingungen aus den Begrenzungseigenschaften der Bauelemente ermittelt. Für eine Eingangsüberlast besteht die Bedingung

$$d_1 X_{max} > a_1 Vref$$

und für eine interne Überlast bestehen die Bedingungen

$$d_i L > a_i Vref, i \in [2, N]$$

und

$$a_i Vref > \frac{L}{2}, i \in [1, N],$$

wobei $X_{max}$ wiederum die maximale Signalamplitude am Eingang X darstellt für die gerade keine Signalbegrenzung auftritt und wobei L den maximale Ausgangsamplitudenbereich der Integratoren $H_1 \ldots H_N$ im Summations/Integrationsverstärker-Netzwerk F definiert, sofern man unterstellt, daß alle Integratoren dieselbe Begrenzungseigenschaft aufweisen. Bezieht man zusätzlich eine prozentuale Bauelementeabweichung D mit ein, können auch alternativ die Überlastbedingungen

$$a_i (1 + D/100) \cdot Vref > L/2 \text{ und}$$

$$d_i \cdot (1 + D/100) \cdot L > a_i (1 - D/100) \cdot Vref$$

verwendet werden.

Als letzter Schritt wird mit Hilfe eines nichtlinearen Optimierungsverfahren unter Beachtung der Überlast und Stabilitätsbedingungen, wobei die Vorwärts- bzw. Rückwärtskoeffizienten des Summations/Integrationsverstärker-Netzwerks variiert werden, das Rauschen $N_0$ minimiert und der Spitzenwert des Signal/Rausch-Verhältnisses $SNR_{peak}$ maximiert, da Sie beide ein Maß für die Leistungsfähigkeit der Rauschunterdrückung bei der erfindungsgemäßen Vorrichtung darstellen. Dabei ist das Rauschen $N_0$ neben dem Signal/Rausch-Verhältnisses $SNR_{peak}$ zusätzlich zu betrachten, weil z. B. beim Rauschen $N_0$ der Koeffizient $d_1$ fehlt.

Eine solche Optimierung kann beispielsweise mit Hilfe des in der Zeitschrift ntz-Archiv, Band 11, 1989, H.3, Seiten 137 bis 151 beschriebenen Programmsystems Candi (Circuit Level Analog Design System for Integrated Circuits) erfolgen.

Eine erfindungsgemäße Vorrichtung zur A/D-Wandlung mit einem Summations/Integrationsverstärker-Netzwerk der Ordnung 3 weist in Richtung des Signalflusses im Vorwärtszweig der Reihe nach die die Vorwärtskoeffizienten $d_1$= 0,2 , d2= 0,35 , d3= 0,4 und die Rückwärtskoeffizienten a1= 0,64*1Volt/Vref, a2=0,76*(1Volt/Vref)*(L/2Volt) und 0,85*(1Volt/Vref)*(L/2Volt) auf.

Ferner weist eine erfindungsgemäße Vorrichtung zur A/D-Wandlung mit einem Summations/Integrationsverstärker-Netzwerk der Ordnung 4 in Richtung des Signalflusses im Vorwärtszweig der Reihe nach die die Vorwärtskoeffizienten $d_1$= 0,17, d2=0,15, d3=0,33 und d4=0,5 und die Rückwärtskoeffizienten a1=0,4*1Volt/Vref, a2=0,5*(1Volt/Vref)*(L/2Volt), a3=0,8*(1Volt/Vref)*(L/2Volt) und a4=1*(1Volt/Vref)*(L/2Volt) auf.

Schließlich weist erfindungsgemäße Vorrichtung zur A/D-Wandlung mit einem Summations/Integrationsverstärker-Netzwerk der Ordnung 5 in Richtung des Signalflusses im Vorwärtszweig der Reihe nach die die Vorwärtskoeffizienten

$d_1$= 0,1, d2=0,1, d3=0,2, d4=0,33 und d5=0,5 und die Rückwärtskoeffizienten a1=0,33*1Volt/Vref, a2=0,4*(1Volt/Vref)*(L/2Volt), a3=0,66*(1Volt/Vref)*(L/2Volt), a4=0,8*(1Volt/Vref)*(L/2Volt) und a5=1*(1Volt/Vref)*(L/2Volt) auf.

Sind innere Rückkoppelschleifen vorhanden , so müssen im oben beschriebenen Verfahren neben den Abhängigkeiten von Vorwärts- und Rückwärtskoeffizienten zusätzlich die Abhängigkeiten von den Schleifenkoeffizienten ... $k_{n-3}$ und $k_{N-1}$ in der Systemfunktion des linearen Modells, in der Systemfunktion zur Beurteilung der Leistungsfähigkeit in den Stabilitätsbedingungen und in den Überlastbedingungen in entsprechender Weise berücksichtigt werden.

Für den Fall eines dreistufigen Summations/Integrationsverstärker-Netzwerkes F ergibt sich bei einem Oversampling-Verhältnis von 32 ein günstiger Schleifenkoeffizient $k_2$ zwischen 0,015 und 0,016, bei einem Oversampling-Verhältnis von 64 ein günstiger Schleifenkoeffizient $k_2$ zwischen 0,004 und 0,005 bei einem Oversampling-Verhältnis von 128 ein günstiger Schleifenkoeffizient $k_2$ zwischen 0,0010 und 0,0011.

## Patentansprüche

1. Vorrichtung zur Analog/Digital-Wandlung, mit einem Summations/Integrationsverstärker-Netzwerk (F), dessen Eingang einen Eingang (X) der Vorrichtung darstellt, dessen Ordnung mindestens 3 beträgt, dessen Vorwärtszweig mindestens drei in Reihe geschaltete Stufen mit je einem Verstärker zur Multiplikation mit Vorwärtskoeffizienten ($d_1$ ... $d_N$), einen Addierer (1 ... N) und einen Integrierer ($H_1$ ... $H_N$) aufweist, dessen Rückwärtszweig mindestens drei Verstärker zur Multiplikation mit den Rückwärtskoeffizienten ($a_1$ ... $a_N$) aufweist und dessen Ausgang mit einem Eingang (U) eines 1-Bit-Quantisierers (ADC) verbunden ist, wobei ein Ausgang des 1-Bit-Quantisierers als Ausgang (Y) der Vorrichtung darstellt und mit einem 1-Bit-D/A-Wandler, dessen Eingang mit dem Ausgang der Vorrichtung und dessen Ausgang mit dem Rückwärtszweig R des Summations/Integrationsverstärker-Netzwerks verbunden sind, und bei der die Vorwärtskoeffizienten ($d_1$ ... $d_N$) und die Rückwärtskoeffizienten ($a_1$ ... $a_N$) dadurch ermittelt sind, daß

   a) eine Systemfunktion eines linearen Modells der Vorrichtung bestimmt wird,

   b) aus der Systemfunktion zur Beurteilung der Leistungsfähigkeit ein Rauschen und ein Spitzenwert eines Signal/Rausch-Verhältnisses als Funktion von Vorwärtskoeffizienten und Rückwärtskoeffizienten ermittelt wird,

   c) aus der Systemfunktion eine von den Vorwärts- und Rückwärtskoeffizienten abhängige Stabilitätsbedingung aus den Polstellen der Systemfunktion ermittelt wird,

   d) ein nichtlineares Modell der Vorrichtung bestimmt wird und daraus Überlastbedingungen ermittelt werden und

   e) mit Hilfe eines Verfahrens zur nichtlinearen Optimierung die Leistungsfähigkeit unter Beachtung der Überlastbedingungen und der Stabilitätsbedingungen maximiert wird.

2. Vorrichtung nach Anspruch 1,
   bei der das Rauschen $N_0$ durch die Beziehung

$$N_0 = 1/\left( \left( \frac{\sqrt{2N+1}}{\pi^N} * \frac{\sqrt{12}}{\Delta} * M^{N+\frac{1}{2}} \right) * \left( a_1 * Vref * \prod_{i=2}^{N} d_i \right) \right)$$

und der Spitzenwert des Rauschverhältnisses $SNR_{peak}$ durch Beziehung

$$SNR_{peak} = \left( X_{max} * \frac{\sqrt{2N+1}}{\pi^N} * \frac{\sqrt{12}}{\Delta} * M^{N+\frac{1}{2}} \right) * \left( \prod_{i=1}^{N} d_i \right)$$

bestimmt wird, wobei $X_{max}$ das Maximum der Amplitude am Eingang (X) der Vorrichtung, N die Ordnung des Summatons/Integrationsverstärker-Netzwerks (F), M das Oversampling-Verhältnis, Vref die Referenzspannung des 1-Bit-D/A-Wandlers, $d_i$ die Vorwärtskoeffizienten des Summations/Integrations-verstärker-Netzwerks (F) und $a_i$ die Rückwärtskoeffizienten des Summations/Integrationsverstärker-Netzwerks (F) sind.

3. Vorrichtung nach Anspruch 1
bei der das Summations/Integrationsverstärker-Netzwerk die Ordnung 3 aufweist, die Vorwärtskoeffizienten ($d_1$ ...$d_3$) in Richtung des Signalflusses im Vorwärtszweig der Reihe nach die Werte 0,2 und 0,35 und 0,4 und die Werte der Rückwärtskoeffizienten ($a_1$ ... $a_3$) in Richtung des Signalflusses im Vorwärtszweig der Reihe nach 0,64*1Volt/Vref, 0,76*(1Volt/Vref)*(L/2Volt) und 0,85*(1Volt/Vref)*(L/2Volt) aufweisen, wobei L der maximale Ausgangsspannungsbereich des Summations/Integrationsverstärker-Netzwerks (F) ist.

4. Vorrichtung nach Anspruch 1 oder 2,
bei der das Summations/Integrationsverstärker-Netzwerk die Ordnung 4 aufweist, die Vowrätskoeffizienten ($d_1$ ... $d_4$) in Richtung des Signalflusses im Vorwärtszweig der Reihe nach 0,17, 0,15, 0,33 und 0,5 und die Werte der Rückwärtskoeffizienten ($a_1$ ... $a_4$) in Richtung des Signalflusses im Vorwärtszweig der Reihe nach 0,4*1Volt/Vref, 0,5*(1Volt/Vref)*(L/2Volt), 0,8*(1Volt/Vref)*(L/2Volt) und 1*(1Volt/Vref)*(L/2Volt) aufweisen, wobei L der maximale Ausgangsspannungsbereich des Summations/Integrationsverstärker-Netzwerks (F) ist.

5. Vorrichtung nach Anspruch 1 oder 2,
bei der das Summations/Integrationsverstärker-Netzwerk die Ordnung 5 aufweist, die Vorwärtskoeffizienten ($d_1$ ... $d_5$) in Richtung des Signalflusses im Vorwärtszweig der Reihe nach die Werte 0,1, 0,1, 0,2, 0,33 und 0,5 und die Rückwärtskoeffizienten ($a_1$ ... $a_5$) in Richtung des Signalflusses im Vorwärtszweig der Reihe nach 0,33*1Volt/Vref, 0,4*(1Volt/Vref)*(L/2Volt), 0,66*(1Volt/Vref)*(L/2Volt), 0,8*(1Volt/Vref)*(L/2Volt) und 1*(1Volt/Vref)*(L/2Volt) aufweisen, wobei L der maximale Ausgangsspannungsbereich des Summations/Integrationsverstärker-Netzwerks (F) ist.

6. Vorrichtung nach Anspruch 1, mit einem das Summations/Integrationsverstärke-Netzwerk (F), dessen Ausgang über einen Vertärker zur Multiplikation mit einem Schleifenkoeffizienten ($k_{N-1}$) mit einem Eingang des Addierers ($N-1$) der übernächsten Vorgängerstufe besschaltet ist und, sofern noch weitere Vorgängerstufen vorhanden sind, Ausgänge von Addierern ($N-1$) über Verstärker zur Multipklikation mit weiteren Schleifenkoeffizienten ($k_{N-3}$) mit Eingängen von Addierern von übernächsten Vorgängerstufen beschaltet sind, bei der, neben den Vorwärtskoeffizienten ($d_1$ ... $d_N$) und die Rückwärtskoeffizienten ($a_1$ ... $a_N$), zusätzlich auch die Schleifenkoeffizienten (... $k_{N-3}$, $k_{N-1}$) in der Systemfunktion des linearen Modells, in der Systemfunktion zur Beurteilung der Leistungsfähigkeit in den Stabilitätsbedingungen und in den Überlastbedingungen berücksichtigt werden.

7. Vorrichtung nach Anspruch 6, mit einem dreistufigen Summations/Integrationsverstärker-Netzwerk (F), dessen Schleifenkoeffizient ($k_2$) bei einem bei einem Oversampling-Verhältnis von 32 zwischen 0,015 und 0,016, bei einem Oversampling-Verhältnis von 64 zwischen 0,004 und 0,005 und bei einem Oversampling-Verhältnis von 128 zwischen 0,0010 und 0,0011 beträgt.

FIG 1

FIG 2

EP 0 765 040 A2